# EUROPEAN PATENT SPECIFICATION

(11) **EP 1 322 795 B1**
(45) Date of publication and mention of the grant of the patent: **15.08.2007**
(21) Application number: 01976619.5
(22) Date of filing: 25.09.2001
(51) Int. Cl.: C23C 14/16, H01J 7/18, F04B 37/04

(54) **POROUS GETTER DEVICES WITH REDUCED PARTICLE LOSS AND METHOD FOR THEIR MANUFACTURE**
PORÖSE GETTERVORRICHTUNGEN MIT VERRINGERTEM TEILCHENVERLUST UND VERFAHREN ZU DEREN HERSTELLUNG
DISPOSITIFS POREUX D'ABSORPTION DE GAZ A PERTE DE PARTICULES REDUITE ET LEUR PROCEDE DE FABRICATION

(30) Priority: 27.09.2000 IT MI002099
(43) Date of publication of application: 02.07.2003
(73) Proprietor: SAES GETTERS S.p.A., 20020 Lainate (Milano) (IT)
(72) Inventor: CONTE, Andrea, I-20154 Milano (IT); MORAJA, Marco, I-20161 Milano (IT)
(74) Representative: Adorno, Silvano
(86) International application number: PCT/IT2001/000488
(87) International publication number: WO 2002/027058

(56) References cited:
- WO-A-00/07209
- WO-A-00/10643
- WO-A-00/75950
- FR-A- 1 132 524

## Description

The present invention relates to a method for manufacturing porous getter devices with reduced particle loss and to the devices so manufactured.

Getter devices can be used in all the technological and scientific applications wherein vacuum maintenance is required, such as, for example, flat displays (of the plasma or field emission type), some kind of lamps or particle accelerators for scientific research. Another important field of use of the getter devices is gas purification, inside fluorescent lamps but mainly in the case of the process gases for microelectronic industry. The invention is also particularly useful for the manufacture of a particular type of getter device, having the shape and size of a substrate to be treated in a deposition chamber such as for instance in a process chamber of the microelectronic industry, wherein the device guarantees a lower evacuation time and a better cleaning of the working atmosphere: this kind of getter device is described in international patent application WO 00/61832 (PCT/IT00/00136) in the name of the applicant.

The active materials which form these devices are mainly zirconium and titanium and alloys thereof with one or more elements selected among transition elements and aluminum. These materials have a strong affinity for gaseous species of low molecular weight, such as oxygen, water, hydrogen, carbon oxides and in some cases nitrogen, and therefore are used for removing traces of these gases from spaces wherein it is requested to maintain the vacuum, or from atmospheres or flows of gases which are inert towards these materials, mainly noble gases.

Since gas sorption takes place through the surface of the getter material, it is generally preferable that this is as wide as possible. In order to obtain this result, and at the same time to maintain small the device size, porous devices are generally used, formed of consolidated powders of getter materials which allow to obtain a high ratio between the exposed surface of active material and the geometrical surface of the getter device.

Various methods for manufacturing porous getters devices are described in the literature.

Patent GB-B-2,077,487 describes the production of porous getter devices formed of a mixture of powders of a getter metal, particularly titanium or zirconium, with a getter alloy; the mixture is precompressed and sintered in a vacuum oven at temperatures comprised between about 800 and 1100 °C. The getter alloy, which has a sintering temperature higher than that of the metal, is added with the antisintering function, in order to avoid an excessive compaction of the powders with following reduction of the gas sorption features.

Patent application DE-A-2,204,714 discloses a process similar to that of the cited patent GB-B-2,077,487, with the difference that in this case graphite powder is used as an antisintering agent.

Getter devices having a porosity degree higher than those obtained by the two previously described techniques can be manufactured by the electrophoretic technique, described for example in patent US 5,242,559. According to this technique, a suspension, generally hydroalcoholic, of particles of a getter material is prepared. In the suspension are inserted two electrodes one of which, made of metal or graphite, will also serve as a support of the final getter device. The transport of the getter material particles towards the support and their adhesion thereon is caused by applying a potential difference between the two electrodes. The so obtained deposit is then consolidated by a sintering thermal treatment in a vacuum oven, generally at temperatures comprised between about 900 and 1000 °C.

Getter devices wherein the active material is in the form of a layer on a planar support can be produced by the screen-printing technique, as described for example in patent US 5,882,727. According to this technique, a paste of getter material particles is prepared in an aqueous solution containing low percentages of an organic compound having a high boiling point, which acts as a binder; this paste is passed through the meshes of a suitable net, and is deposited on the underlying substrate. The deposit is then dried and consolidated by sintering in a vacuum oven at a temperature comprised between about 800 and 1000 °C.

Finally, getter devices having a particularly high porosity degree can be obtained according to the technique described in patent US 5,908,579. In this case it is used a mixture of powders of the getter material and of an organic component, for example ammonium carbamate, which evaporates during the thermal treatments of consolidation of the device (treatments which reach temperatures comprised between 900 and 1200 °C), leaving a net of interconnected porosities which allow the access of gases to the surface of the innermost particles of getter material in the device. WO 00/10643 disclosures a getter material provided with a diamond film

A problem encountered with the getter devices according to the known art is the possibility of loss of particles, due to the fact that the surface particles can be bound more weakly than the most internal ones. The presence of free particles is harmful for most of the foreseen applications of the getter devices, because these may interfere with the electric functionality (for example in the case of flat displays), they may come between the path of radiations or elementary particle beams (applications in particle accelerators) or they may deposit on microelectronic devices which are being manufactured.

A possible way to obviate the problem is to increase the sintering temperature, thus favoring the mutual adhesion of the particles; however, not only this method reduces the entity of the problem without solving it, but has also the disadvantage that it leads to a reduction of the porosity and of the exposed area of the active material, and consequently to a reduction of the gas sorption properties of the getter devices.

Object of the present invention is providing a method for manufacturing porous getter devices with reduced particle loss without the drawbacks of the known art, as well as to provide the resulting devices.

This object is obtained by the method according to the present invention, which consists in producing on the surface of the porous getter body a deposit of thickness of at least 0,5 µm of a material compatible with the conditions of use foreseen for the getter device, with a technique selected among evaporation, deposition from arc generated plasma, deposition from ionic beam and cathodic deposition.

The inventors have found that, in contrast to what was believable a priori, the deposition of a suitable material in low thickness on the surface of a porous getter body does not prejudice its gas sorption properties, sensibly reducing at the same time the phenomenon of particles loss.

The invention will be described in the following with reference to the figures, wherein:
- Figure 1 shows schematically a cross-sectional view of a porous getter body before the covering according to the method of the invention;
- Figure 2 shows the same cross-section of the porous getter body of figure 1 after the covering according to the method of the invention;
- Figure 3 shows the cross-section of a few grains of getter material covered according to a preferred embodiment of the method of the invention.

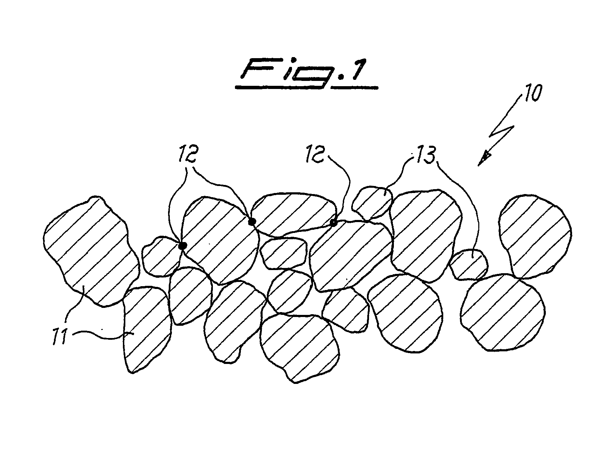

Figure 1 shows in cross-section the surface portion of a porous getter body 10. The particles of getter material 11 are connected together through "necks" 12, wherein during the sintering microfusions of the material take place. The adhesion of the surface particles to the rest of the structure can be reduced because of a scarce mechanical resistance of these necks (due to a low temperature of the sintering process) or to their reduced number, in particular in the case of particles 13 of a small size.

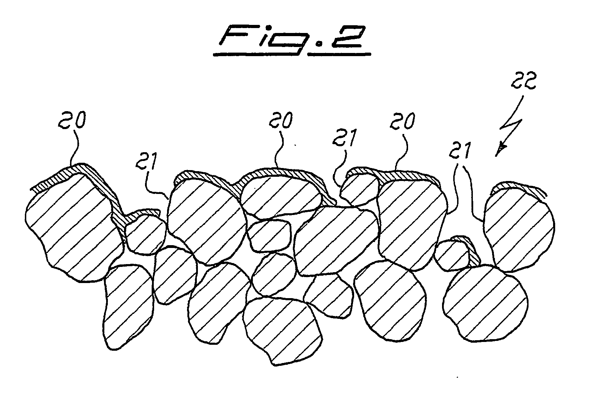

Figure 2 represents the same body of figure 1 with covering according to the method of the invention. The upper surface of body 10 is covered with a layer 20 obtained by one of the cited techniques. These techniques are directional, and the deposit covers only the portion of body 10 which is exposed towards the source of the material which is deposited. Some zones (21) of the surface getter particles, which are in the "shadow area" with respect to the source of the material to be deposited, remain thus free from the deposit. The total effect is that deposit 20 acts as a glue of the surface particles, but it does not clog the large channels among getter material particles, which allow gases access towards the innermost particles, whose surface is not covered in the method according to the invention and therefore remains active for the gas sorption. The result is a porous getter body 22 superficially covered by the deposit 20.

The porous getter body on which the deposit 20 is to be formed can be produced according to any one of the previously mentioned techniques, that is powder compression with or without organic components which evaporate during the subsequent thermal treatments, electrophoresis and screen-printing.

The getter materials which can be used for the production of the porous body are various, and generally comprise titanium and zirconium metals, their hydrides, titanium or zirconium alloys with one or more elements selected among transition elements and aluminum, and mixtures of one or more of these alloys with titanium and/or zirconium or their hydrides. Among the most useful materials for the purposes of the invention can be mentioned the alloys Zr-Al described in patent US 3,203,901 and particularly the alloy having weight percent composition Zr 84% - Al 16%, produced and sold by the applicant under the name St 101; the alloys Zr-V-Fe described in patent US 4,312,669 and particularly the alloy having weight percent composition Zr 70%- V 24.6% - Fe 5.4%, produced and sold by the applicant with the name St 707; the alloys Zr-Co-A (wherein A indicates an element selected among yttrium, lanthanum, Rare Earths or mixtures thereof) described in patent US 5,961,750, and particularly the alloy having weight percent composition Zr 80.8%-Co 14.2%- A 5%, manufactured and sold by the applicant with the name St 787; the alloys Ti-V-Mn disclosed in patent US 4,457,891; the mixture comprising, by weight, 70% of Ti and 30% of alloy St 101; the mixture comprising 70% of Ti and 30% of alloy St 707; the mixture comprising 40% of Zr and 60% of alloy St 707; the mixture comprising 60% of Ti and 40% of alloy St 707; and the mixture comprising, by weight, 10% of Mo, 80% of Ti and 10% of TiH₂, described in patent US 4,428,856, produced and sold by applicant with the name St 175. These getter materials are generally employed in the form of powders of particle size lower than about 125 µm, and preferably between about 20 and 100 µm.

After the manufacture of the getter body according to one of the cited techniques, it is consolidated by means of a thermal sintering treatment under vacuum or inert atmosphere, at temperatures generally comprised between 800 and 1200 °C according to the materials used.

The getter body so obtained is subjected to the treatment of deposition of the layer of thickness of at least 0,5 µm with a technique selected among evaporation, deposition from arc generated plasma, deposition from ionic beam and cathodic deposition.

Evaporation can be carried out placing in the same chamber the getter specimen to be covered and a source of the material to be deposited, this latter being evaporated (under inert gas or vacuum) by known techniques, such as direct heating (e.g., by passing current in the material holder), indirect heating (e.g., induction heating), electronic bombardment or similar means.

The second technique (better known with the definition arc plasma deposition) consists in creating microscopic drops of the material which has to be deposited by melting the surface of a solid body of the same material with a localized arc; the drops so formed are then accelerated towards the substrate which has to be covered. The technique enables compact coverings to be obtained quickly, and is used for example for covering mechanical tools in order to improve the hardness features thereof.

The technique of deposition from ionic beam, better known with the definition ion beam deposition, consists in creating a plasma of ions of the material to be deposited, and then accelerating these ions towards the substrate to be covered by means of an electric field.

For the purposes of the invention, preferred is the use of the cathodic deposition technique. The cathodic deposition technique allows the production of thin layers, of thickness values generally up to about 10-20 µm, of a material on a support generally formed of a different material. The technique has a large number of variants, and is better known in the field with the definitions of "sputtering" (which will be used in the rest of the text) or "physical vapor deposition" or its acronym "PVD". The sputtering technique is widely known and used in the industry, and particularly it is fundamental for the microelectronic industry, since it allows the production of thin layers of active materials (for example, layers of conductor materials) or with a passive functionality (for example insulants), but has also an application in a number of further fields, for example for manufacturing the layer of aluminum of the compact disks.

The sputtering and the variations thereof are extremely known and numerous, and will be not described in detail here. In order to understand the invention it is sufficient to recall the basis of the technique. As it is well known, in this technique is used a vacuum chamber wherein it is possible to generate an electric field. In the chamber are placed a target of the material which is to be deposited (generally having the shape of a short cylinder) and, in front of the target, the support on which the thin layer is to be formed. The chamber is first evacuated and then filled with an atmosphere of a noble gas, generally argon, at a pressure of 10⁻²-10⁻⁵ mbar; by applying a potential difference of a few thousands of volts between the backings of the support and of the target (so that the latter is at cathode potential) a plasma of electrons and Ar⁺ ions is generated; these ions are accelerated by the electric field towards the target thus causing the impact erosion thereof; the species (generally atoms or "clusters" of atoms) derived from the erosion of the target deposit on the support thus forming the thin layer thereof. By varying the process parameters, the properties and the conditions of the film manufacturing are controlled; for example, by increasing the power applied at the electrodes, the thickness produced in the same time is increased and the morphology of the obtained thin layer is changed; the morphology can be controlled in an even more efficient way by varying the incident angle of deposition with respect to the substrate.

The thickness of the layer deposited on the surface of the porous getter must be at least 0,5 µm, because at lower values the cohesion of the layer is not sufficient for retaining the particles of getter material scarcely bound to the rest of the device. The upper limit of the thickness of the deposit is not strictly defined, but this is generally lower than 5 µm, because for higher thickness values there are long process times without obtaining particular advantages. Preferably, the thickness of the deposit is comprised between 1 and 2,5 µm.

The material for forming the deposit can be any material compatible with the conditions of use of the device in the final application. In particular, the material of the deposit must have a low gas release and must be able to withstand without alterations the temperatures to which the getter device is subjected during the manufacturing steps of the devices to which it is destined, such as the fritting operations for sealing flat displays or lamps; in the case of the devices having shape and size of the substrates to be treated in a deposition chamber, described in the above cited international patent application PCT/IT00/00136, the material deposited on the porous getter body must be able to withstand the heating at the activation temperature of the getter material, and at least at temperatures around 500 °C whereto the chamber is subjected in order to degas the walls thereof. In general, the deposited material can be selected among transition metals, Rare Earths and aluminum. It is also possible to deposit more than one metal at a time (with techniques such as co-evaporation or the so-called "co-sputtering"), thus obtaining mixtures or alloys of the cited metals.

Preferably, the deposited material is a metal having also getter properties, such as vanadium, niobium, hafnium, tantalum, or preferably titanium and zirconium, or alloys of these metals. In the case of the deposition of one of these materials, besides the reduced particle loss, also increases of the gas sorption properties compared to the not covered porous body are obtained.

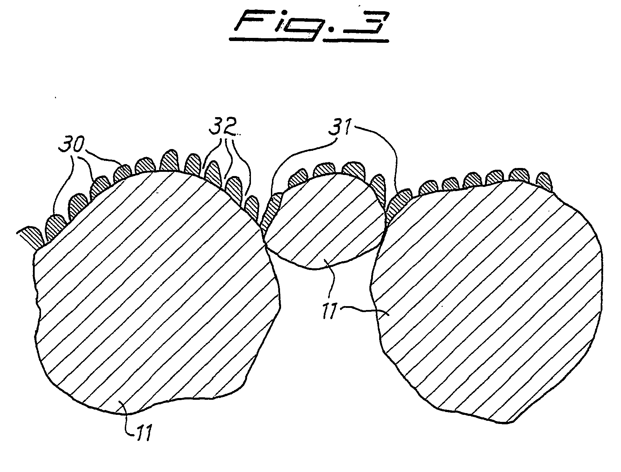

Particularly good results from this standpoint are obtained if the layer is deposited in granular or columnar morphology. An example of surface of a porous getter body covered with a deposit having this morphology is represented in figure 3, which shows superficial getter grains 11 covered by a multiplicity of microdeposits 30, anyway able to carry out the function of a glue for the grains at areas 31, but within which are present microchannels 32 which improve the accessibility of the gases to the underlying porous getter, and also to the surface of the same covered getter grains. The granular or columnar morphology can be obtained through the sputtering technique by controlling the deposition conditions, and particularly by operating at high pressure of the noble gas and at low temperature of the substrate (the porous getter); preferably, the gas pressure is maintained between about 1x10⁻³ and 5x10⁻² mbar, and the temperature of the substrate is close to the room temperature.

## Claims

1. A method for manufacturing porous getter devices (22) with reduced particle loss consisting in producing on the surface of the porous getter body (10) a deposit (20; 30, 31) having thickness of at least 0,5 µm of a material compatible with the conditions of use of the getter device, selected among transition metals, Rare Earths and aluminum with a technique selected among evaporation, deposition from arc generated plasma, deposition from ionic beam and cathodic deposition.

2. A method according to claim 1 wherein the porous getter body to be covered is manufactured by a process selected among compression of powders with or without organic components which evaporate during the subsequent thermal treatments, electrophoresis and serigraphy.

3. A method according to claim 1 wherein the getter material of the porous body is selected among the metals titanium and zirconium, their hydrides, alloys of titanium or zirconium with one or more elements selected among transition metals and aluminum, and mixtures of one or more of these alloys with titanium and/or zirconium or hydrides thereof.

4. A method according to claim 3 wherein the getter material is an alloy having weight percent composition Zr 84% -Al 16%.

5. A method according to claim 3 wherein the getter material is an alloy having weight percent composition Zr 70% - V 24.6% - Fe 5.4%.

6. A method according to claim 3 wherein the getter material is an alloy having weight percent composition Zr 80.8% - Co 14.2% - A 5%, wherein A indicates an element selected among yttrium, lanthanum, Rare Earths or mixtures thereof.

7. A method according to claim 3 wherein the getter material is a mixture comprising, by weight, 70% of Ti and 30% of the alloy having weight percent composition Zr 84% - Al 16%.

8. A method according to claim 3 wherein the getter material is a mixture comprising, by weight, 70% of Ti and 30% of the alloy having weight percent composition Zr 70% - V 24.6% - Fe 5.4%.

9. A method according to claim 3 wherein the getter material is a mixture comprising, by weight, 40% of Zr and 60% of the alloy having weight percent composition Zr 70% - V 24.6 % - Fe 5.4%.

10. A method according to claim 3 wherein the getter material is a mixture comprising, by weight, 60% of Ti and 40% of the alloy having weight percent composition Zr 70% - V 24.6 % - Fe 5.4%.

11. A method according to claim 3 wherein the getter material is a mixture comprising, by weight, 10% of Mo, 80% of Ti and 10% of TiH₂.

12. A method according to claim 1 wherein the getter material is in the form of powders of particle size lower than 125 µm.

13. A method according to claim 12 wherein the getter material is in the form of powders of particle size comprised between about 20 and 100 µm.

14. A method according to claim 1 wherein said deposit has a thickness lower than 5 µm.

15. A method according to claim 14 wherein said deposit has a thickness comprised between 1 and 2,5 µm.

16. A method according to claim 15 wherein the material deposited is selected among vanadium, niobium, hafnium, tantalum, titanium and zirconium.

17. A method according to claim 16 wherein the material is deposited by cathodic deposition obtaining a layer with granular or columnar morphology.

18. A method according to claim 17 wherein the cathode deposition is carried out at a noble gas pressure comprised between about 1x10⁻³ and 5x10⁻² mbar, and at a temperature of the porous getter body close to the room temperature.

19. Porous getter body (22) formed of particles (11) of getter material connected together, wherein only the getter particles at the upper surface of said body are partially covered with a deposit (20; 30, 31) of a material selected among transition metals, Rare Earths and aluminum, said deposit having thickness of at least 0,5 µm, while the getter particles which are internal in the getter body and not at said upper surface are free from said deposit.

## Patentansprüche

1. Ein Verfahren zur Herstellung poröser Gettereinrichtungen (22) mit verringertem Teilchenverlust, bestehend in der Erzeugung eines Niederschlags (20; 30, 31) mit einer Dicke von wenigstens 0,5 µm aus einem Material, das kompatibel ist mit der Verwendung der Gettereinrichtung, ausgewählt aus Übergangsmetallen, Seltenen Erden und Aluminium, mit einem Verfahren, ausgewählt aus Verdampfung, Abscheidung aus einem durch Flammenbogen erzeugtem Plasma, Abscheidung aus Ionenstrahlung und kathodischer Abscheidung auf der Oberfläche eines porösen Getterkörpers (10).

2. Ein Verfahren nach Anspruch 1, worin der poröse zu beschichtende Getterkörper durch ein Verfahren hergestellt ist, das ausgewählt ist aus der Kompression von Pulvern mit oder ohne organischen Bestandteilen, die während der folgenden thermischen Behandlungen, Elektrophorese und Serigraphie verdampfen.

3. Ein Verfahren nach Anspruch 1, worin das Gettermaterial des porösen Körpers ausgewählt ist aus den Metallen Titan und Zirkon, deren Hydriden, Legierungen von Titan oder Zirkon mit einem oder mehreren Elementen, ausgewählt unter den Übergangsmetallen und Aluminium, und Gemischen von einer oder mehrerer dieser Legierungen mit Titan und/oder Zirkon oder deren Hydriden.

4. Ein Verfahren nach Anspruch 3, worin das Gettermaterial eine Legierung mit einer Zusammensetzung in Gew.% von Zr 84 % - Al 16 % ist.

5. Ein Verfahren nach Anspruch 3, worin das Gettermaterial eine Legierung mit einer Zusammensetzung in Gew.% von Zr 70 % - V 24,6 % - Fe 5,4 % ist.

6. Ein Verfahren nach Anspruch 3, worin das Gettermaterial eine Legierung mit einer Zusammensetzung in Gew.% von Zr 80,8 % - Co 14,2 % - A 5 %, worin A ein Element, ausgewählt aus Yttrium, Lanthan, Seltenen Erden oder deren Gemischen, angibt.

7. Ein Verfahren nach Anspruch 3, worin das Gettermaterial ein Gemisch ist, enthaltend in Gew.% 70 % Ti und 30 % einer Legierung mit einer Zusammensetzung von Zr 84 % - Al 16 %.

8. Ein Verfahren nach Anspruch 3, worin das Gettermaterial ein Gemisch ist, enthaltend in Gew.% 70 % Ti und 30 % einer Legierung mit einer Zusammensetzung in Gew.% Zr 70 % - V 24,6 % - Fe 5,4 %.

9. Ein Verfahren nach Anspruch 3, worin das Gettermaterial ein Gemisch ist, enthaltend in Gew.% 40 % Zr und 60 % einer Legierung mit einer Zusammensetzung in Gew.% von Zr 70 - V 24,6 % - Fe 5,4 %.

10. Ein Verfahren nach Anspruch 3, worin das Gettermaterial ein Gemisch ist, enthaltend in Gew.% 60 % Ti und 40 % einer Legierung mit einer Zusammensetzung in Gew.% von Zr 70 % - V 24,6 % - Fe 5,4 %.

11. Ein Verfahren nach Anspruch 3, worin das Gettermaterial ein Gemisch ist, enthaltend in Gew.% 10 % Mo, 80 % Ti und 10 % TiH₂.

12. Ein Verfahren nach Anspruch 1, worin das Gettermaterial in Form eines Pulvers mit einer Teilchengröße kleiner als 125 µm vorliegt.

13. Ein Verfahren nach Anspruch 12, worin das Gettermaterial in Form eines Pulvers einer Teilchengröße zwischen 20 und 100 µm vorliegt.

14. Ein Verfahren nach Anspruch 1, worin der Niederschlag eine Dicke von weniger als 5 µm aufweist.

15. Ein Verfahren nach Anspruch 14, worin der Niederschlag eine Dicke zwischen 1 und 2,5 µm aufweist.

16. Ein Verfahren nach Anspruch 15, worin das abgeschiedene Material ausgewählt ist aus Vanadium, Niob, Hafnium, Tantalum, Titan und Zirkon.

17. Ein Verfahren nach Anspruch 10, worin das Material durch kathodische Abscheidung abgeschieden wird und wobei eine Schicht mit einer körnigen oder säulenartigen Morphologie erzielt wird.

18. Ein Verfahren nach Anspruch 17, worin die Kathodenabscheidung bei einem Edelgasdruck zwischen etwa 1x10⁻³ und 5x10⁻² mbar durchgeführt wird und bei einer Temperatur des porösen Getterkörpers nahe der Raumtemperatur.

19. Poröser Getterkörper (22), gebildet aus miteinander verbunden Teilchen (11) des Gettermaterials, worin nur die Getterteilchen der oberen Oberfläche dieses Körpers teilweise mit einer Abscheidung (20; 30, 31) des Materials, ausgewählt aus Übergangsmetallen, Seltenen Erden und Aluminium, bedeckt sind, diese Bedeckung weist eine Dicke von wenigstens 0,5 µm auf, während die Getterteilchen, die im Inneren des Getterkörpers und nicht an der besagten Oberfläche vorliegen, frei sind von dieser Abscheidung.

## Revendications

1. Procédé pour fabriquer des dispositifs getter poreux (22) ayant une perte de particules réduite consistant à produire sur la surface du corps getter poreux (10) un dépôt (20 ; 30, 31) ayant une épaisseur d'au moins 0,5 µm constitué d'un matériau compatible avec les conditions d'utilisation du dispositif getter, choisi parmi des métaux de transition, des Terres Rares et de l'aluminium, à l'aide d'une technique choisie parmi une évaporation, un dépôt à partir de plasma généré par arc, un dépôt à partir d'un faisceau ionique et un dépôt cathodique.

2. Procédé selon la revendication 1, dans lequel le corps getter poreux à recouvrir est fabriqué par un processus choisi parmi une compression de poudres avec ou sans composants organiques qui s'évaporent pendant les traitements thermiques ultérieurs, une électrophorèse et une sérigraphie.

3. Procédé selon la revendication 1, dans lequel le matériau getter du corps poreux est choisi parmi les métaux titane et zirconium, leurs hybrides, alliages de titane ou zirconium avec un ou plusieurs éléments choisis parmi des métaux de transition et de l'aluminium, et des mélanges d'un ou plusieurs de ces alliages avec du titane et/ou du zirconium ou des hybrides de ceux-ci.

4. Procédé selon la revendication 3, dans lequel le matériau getter est un alliage ayant une composition en pourcentage en poids de 84 % de Zr-16 % de Al.

5. Procédé selon la revendication 3, dans lequel le matériau getter est un alliage ayant une composition en pourcentage en poids de 70 % de Zr-24,6 % de V-5,4 % de Fe.

6. Procédé selon la revendication 3, dans lequel le matériau getter est un alliage ayant une composition en pourcentage en poids de 80,8 % de Zr-14,2 % de Co-5 % de A, où A désigne un élément choisi parmi l'yttrium, le lanthane, des Terres Rares ou des mélanges de ceux-ci.

7. Procédé selon la revendication 3, dans lequel le matériau getter est un mélange comportant, en poids, 70 % de Ti et 30 % de l'alliage ayant une composition en pourcentage en poids de 84 % de Zr-16 % de Al.

8. Procédé selon la revendication 3, dans lequel le matériau getter est un mélange comportant, en poids, 70 % de Ti et 30 % de l'alliage ayant une composition en pourcentage en poids de 70 % de Zr-24,6 % de V-5,4 % de Fe.

9. Procédé selon la revendication 3, dans lequel le matériau getter est un mélange comportant, en poids, 40 % de Zr et 60 % de l'alliage ayant une composition en pourcentage en poids de 70 % de Zr-24,6 % de V-5,4 % de Fe.

10. Procédé selon la revendication 3, dans lequel le matériau getter est un mélange comportant, en poids, 60 % de Ti et 40 % de l'alliage ayant une composition en pourcentage en poids de 70 % de Zr-24,6 % de V-5,4 % de Fe.

11. Procédé selon la revendication 3, dans lequel le matériau getter est un mélange comportant, en poids, 10 % de Mo, 80 % de Ti et 10 % de TiH₂.

12. Procédé selon la revendication 1, dans lequel le matériau getter est sous la forme de poudres ayant une taille de particules inférieure à 125 µm.

13. Procédé selon la revendication 12, dans lequel le matériau getter est sous la forme de poudres ayant une taille de particules comprise entre environ 20 et 100 µm.

14. Procédé selon la revendication 1, dans lequel ledit dépôt a une épaisseur inférieure à 5 µm.

15. Procédé selon la revendication 14, dans lequel ledit dépôt a une épaisseur comprise entre 1 et 2,5 µm.

16. Procédé selon la revendication 15, dans lequel le matériau déposé est choisi parmi le vanadium, le niobium, l'hafnium, le tantale, le titane et le zirconium.

17. Procédé selon la revendication 16, dans lequel le matériau est déposé par dépôt cathodique en obtenant une couche ayant une morphologie granulaire ou de type colonne.

18. Procédé selon la revendication 17, dans lequel le dépôt cathodique est effectué à une pression en gaz noble comprise entre environ 1 × 10⁻³ et 5 × 10⁻² mbar, et à une température du corps getter poreux proche de la température ambiante.

19. Corps getter poreux (22) formé de particules (11) d'un matériau getter reliées ensemble, dans lequel seules les particules getter au niveau de la surface supérieure dudit corps sont partiellement recouvertes d'un dépôt (20 ; 30, 31) constitué d'un matériau choisi parmi des métaux de transition, des Terres Rares et de l'aluminium, ledit dépôt ayant une épaisseur d'au moins 0,5 µm, alors que les particules getter qui sont à l'intérieur du corps getter et non au niveau de ladite surface supérieure, sont exemptes dudit dépôt.
